# EUROPÄISCHE PATENTSCHRIFT

(11) **EP 0 347 686 B1**
(45) Veröffentlichungstag und Bekanntmachung des Hinweises auf die Patenterteilung: **08.12.1993**
(21) Anmeldenummer: 89110537.1
(22) Anmeldetag: 10.06.1989
(51) Int. Cl.: H03J 1/16, H03J 1/22, H01H 25/06

(54) **Drehbetätigter Geber für digitale Impulse und Anwendungsverfahren für diesen**
Rotating transmitter for digital pulses, and method of using it
Transmetteur rotatif pour impulsions numériques et son procédé d'application

(30) Priorität: 22.06.1988 DE 3821004
(43) Veröffentlichungstag der Anmeldung: 27.12.1989
(73) Patentinhaber: Deutsche Thomson-Brandt GmbH, 78003 Villingen-Schwenningen (DE)
(72) Erfinder: Hake, Martin, D-7730 Villingen-Schwenningen (DE); Kaaden, Jürgen, D-7730 Villingen-Schwenningen (DE)

(56) Entgegenhaltungen:
- EP-A- 0 015 161
- EP-A- 0 157 373
- DE-A- 2 822 672
- DE-B- 1 260 003
- US-A- 3 177 432

## Beschreibung

Die Erfindung betrifft ein Verfahren zur Anwendung eines drehbetätigten Endlos-Gebers für digitale Impulse nach dem Oberbegriff des ersten Anspruchs.

Derartige Impulsgeber sind in der Digitaltechnik als Digital-Encoder bekannt. Sie bestehen aus einer drehbaren Scheibe, die mechanisch durch Schleifkontakte, optisch durch opto-elektronische Sonsoren oder magnetisch auf dem Halleffekt beruhend oder auch induktiv abtastbar sind. Die Scheibe wird dabei an dem impulsauslösenden Element wie Schleifer, Photodiode, Hallelement oder Spule vorbeibewegt. Es handelt sich dabei um zwei Sensoren, die um einen bestimmten Winkel versetzt angeordnet sind. Aus den von diesen gelieferten phasenverschobenen Impulsreihen kann auf die Drehrichtung des Impulsgebers geschlossen werden, so daß z.B. ein an diesen angeschlossener Zähler aufwärts oder abwärts zählt, von welchem das Zählergebnis digital oder nach einer Umwandlung analog ausgewertet werden kann. Impulsgeber und Anwendungsverfahren der vorbeschriebenen Arten sind in der Digitalelektronik weit verbreitet und gewinnen auch in der Unterhaltungselektronik mehr an Bedeutung. Ein Beispiel dafür ist der in DE-A-2822 672 beschriebene Impulsgeber In einer noch nicht veröffentlichten Patent-Anmeldung 37 31 784. sind unterschiedliche, funktionsabhängig umschaltbare mechanische Drehmomente für einen derartigen Geber beschrieben. Der Impulsgeber wird meist mehrfach ausgenutzt, indem er nacheinander je nach Bedienungsbefehl des Gerätebenutzers unterschiedliche Funktionen steuert.

So ist es z.B. möglich, durch diesen einzigen Impulsgeber die Sendereinstellung, die Lautstärkeeinstellung, die Tiefen- und Höheneinstellung sowie die Tonbalance des Gerätes zu verändern. Das geschieht in der Weise, daß dem Impulsgeber durch Vorwahltasten diese verschiedenen Funktionen zugeordnet werden.

Der vorliegenden Erfindung lag die Aufgabe zugrunde, die diversen genannten Vorwahltasten zu vermeiden und so eine einfachere Bedienung für Mikrocomputer gesteuerte Geräte zu erzielen, die eine vorteilhafte, übersichtliche Einhandbedienung bietet.

Das wird erfindungsgemäß durch ein Verfahren für die Anwendung eines Drehgebers und seine Ausbildung nach den beiden ersten Ansprüchen erreicht. Weitere Ausgestaltungen und Einzelheiten sind den Unteransprüchen zu entnehmen sowie der Zeichnung. Die Kombination von durch Drehung einstellbaren Bauteilen miteinem durch Druck auf die Achse betätigten Schalter ist an sich bekannt. So beschreibt EP-A- 0157 373 die kombination eines Patentiometers mit einem durch Druck auf die Achse betätigten Schalter.

Die Lösung nach der Erfindung erlaubt es durch ein Anwendungsverfahren einen durch Druck oder Zug betätigten Schalter, der mit dem Drehgeber gekoppelt ist, so einzusetzen, daß der Aufruf des Drehgebers durch ein Schaltsignal desselben erfolgt und daß mittels Drehgeber-Betätigung die Einstellfunktion angewählt wird. Nachfolgend wird durch ein Schaltsignal des Schalters die Auswahl quittiert. Danach kann mittels des Drehgebers die Einstellung vorgenommen oder zu einer Unterfunktion durchgeschaltet werden. Ein neuer Schaltbefehl veranlaßt das Verlassen der gewählten Funktion, gegebenenfalls zyklische Weiterschaltung und/oder die abschließende Speicherung der Einstellung. Der Aufruf des Drehgebers sowie die Auswahl der Einstellfunktion wird durch Druck oder Zug am Bedienknopf des Drehgebers vorzugsweise um diesen Knopf herum, durch beschriftete Felder, die beispielsweise bei Anwahl von hinten beleuchtet werden, evtl. auch durch ein gleichzeitiges akustisches Signal, gekennzeichnet. Das kann mit Leuchtdioden geschehen oder mittels entsprechender Anzeigeelemente.

Ein Ausführungsbeispiel der Erfindung ist in der Zeichnung dargestellt. Diese zeigt in
- Figur 1: in vereinfachter Ausführung einen Drehgeber mit Druckschalter in Seitenansicht;
- Figur 2: die Anordnung von Anzeigefeldern um den Bedienknopf eines Drehgebers herum;
- Figur 3 A und 3 B: eine schematische Darstellung des Anwendungsverfahrens für einen Drehgeber mit einem Druck-/Zug-Schalter, wobei beide Teile der Darstellung 3A bei (A) und (B) miteinander kooperieren, indem der Programmteil 2 aus Figur 3A und Figur 3B im Detail wiedergegeben ist.

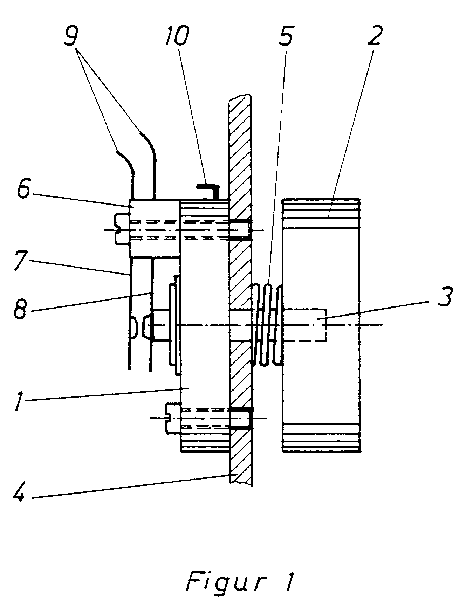

Wie der Figur 1 zu entnehmen ist, ist ein Drehgeber 1 an eine Gehäusewand 4 (Frontseite des Geräts) befestigt. Auf seiner Achse 3 ist ein Bedienknopf 2 befestigt und stützt sich gegen die Druckfeder 5 ab. Die Achse 3 ist im Drehgeber 1 axial beweglich um einen Druckschalter 6 mit den Kontakten 7 und 8 zu betätigen, der die Anschlußfahnen 9 hat. Der Drehgeber hat mehrere Ausgänge, der Anschluß 10 ist gezeigt.

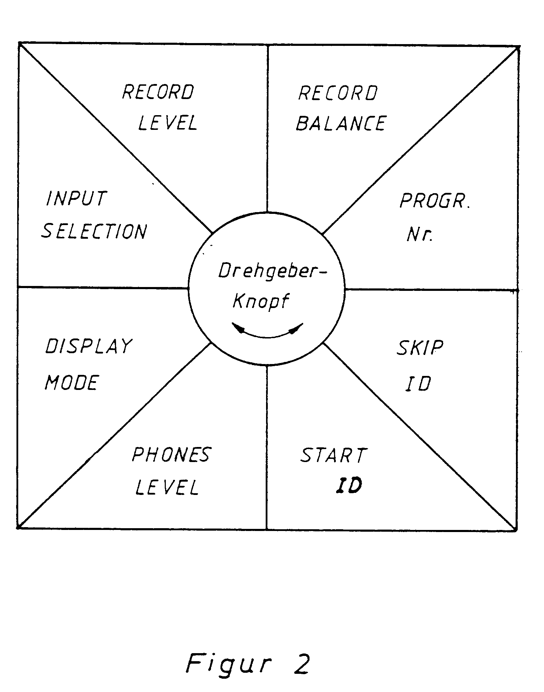

Figur 2 zeigt um den zentralen Drehgeberknopf radial angeordnete Anzeigefelder, die nach Aufruf und Quittierung von hinten einzeln selektiv beleuchtet werden von nicht gezeigten Beleuchtungsquellen wie z.B. Leuchtdioden. Die Bedeutung der beispielhaften Anzeigefelder-Beschriftung ist nachstehend aufgelistet:
Record Level = Aufnahme Pegel
Record Balance = Aufnahme Balance
Pro.Nr. = Programm Nummer
Skip ID = Sprung Erkennung
START ID = Anfangs-Erkennung
Phones Level = Kopfhörer-Lautstärke-Pegel
Display Mode = Anzeige Betriebsart
Input-Select = Eingangs Auswahl.

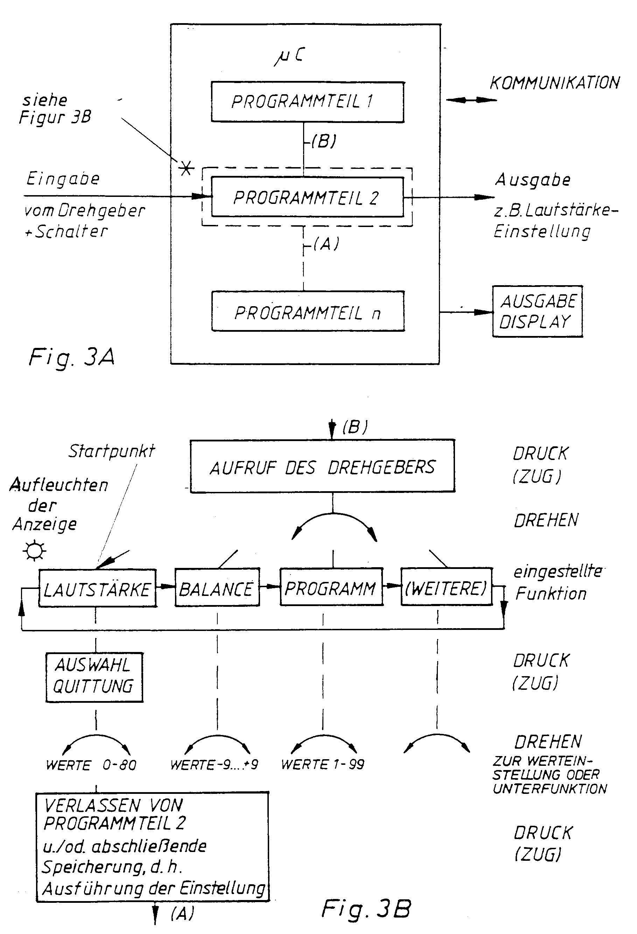

Figur 3 soll die Arbeitsweise des Anwendungsverfahresn verständlich machen. Figur 3A zeigt einen Mikrocomputer µ C mit den Programmteilen 1, 2 und n. Der Programmteil 1 dient der Kommunikation. Am Programmteil 2 werden am Anschluß "Eingabe" die Schaltsignale vom Druck- bzw. Zugschalter und die Impulsfolgen vom Drehgeber eingegeben. Seine "Ausgabe" steuert in der dargestellten Betriebsart "Lautstärke". Außerdem gibt es am Mikrocomputer einen Ausgang für "Ausgabe-Display" (-Anzeige).

Figur 3B zeigt den Programmteil 2 zwischen den Anschlüssen (A) und (B) im Einzelnen. Rechts seitlich von dem symbolischen Blockdiagramm sind die Bedienung von Drehgeber und Druck-(Zug-)Schalter, die in der Reihenfolge von oben nach unten den Ablauf des Verfahrens der Anwendung wiedergeben.

Am Startpunkt ruft das erste Schaltsignal den Drehgeber auf. Impulsfolgen vom Drehgeber bewirken die Einstellung einer Funktion, hier "Lautstärke". Die zurückgeführte Pfeilverbindung soll den zyklischen Ablauf der Einstellung andeuten, d.h. nach "(weitere)" wieder zurück zu "Lautstärke". Nach der Einstellung der Funktion veranlaßt ein neues Schaltsignal die Quittung der Funktionsauswahl. Das kann z.B. das Aufleuchten eines Anzeigefeldes zur Folge haben. Erneutes Drehen am Drehgeber verursachte durch die abgegebene Impulsfolge die gewünschte Werteinstellung der Funktion oder eine Unterfunktion. Eine Schalterbetätigung anschließend kann je nach Programmierung durch das Schaltsignal das Verlassen des Programmteils 2 und/oder eine abschließende Speicherung (im Sinne einer Ausführung der Einstellung) veranlassen.

Andere vorteilhafte Ausgestaltungen (Programmierung) sind durch das beschriebene Verfahrensbeispiel für die Anwendung des mit einem Schalter kombinierten Drehgebers nicht ausgeschlossen. Im Rahmen der Erfindung sind eine Vielzahl von vorteilhaften Ausgestaltungen des Anwendungsverfahrens denkbar.

## Patentansprüche

1. Verfahren für die Anwendung eines drehbetätigten Endlos-Gebers für digitale Impulse in einem Gerät der Unterhaltungselektronik, der bei Betätigung eine von zwei je nach Drehrichtung zueinander phasenverschobene Impulsfolgen erzeugt, die mittels elektronischer Schaltungsmittel im Zusammenwirken mit einem Mikrocomputer ermöglichen, die Drehrichtung zu erkennen, dadurch gekennzeichnet, daß die Drehbewegung des Gebers sowohl zur Funktionsanwahl als auch zur Einstellung der Funktion benutzt wird und ein mit dem Drehgeber gekoppelter Schalter durch Abgabe von Schaltsignalen in verabredeter Reihenfolge dem Drehgeber die Funktionen Auswahl oder Funktionen Einstellung sowie Quittierungs- und/oder Speichervorgänge zuordnet, d.h., die Ausführung der Einstellung aufruft.

2. Verfahren für die Anwendung eines Endlos-Gebers nach Anspruch 1, dadurch gekennzeichnet, daß der mit dem Drehgeber gekoppelte Schalter als ein durch Druck und/oder Zug betätigbarer Schalter ausgebildet ist.

3. Verfahren für die Anwendung eines Endlos-Gebers nach Anspruch 1, dadurch gekennzeichnet, daß für jede gerade angewählte Funktion eine entsprechende Rückmeldung optischer und/oder akustischer Art über dafür vorgesehene Mittel erfolgt.

4. Verfahren für die Anwendung eines Endlos-Gebers nach Anspruch 1, dadurch gekennzeichnet, daß die Anzeigen aus Leuchtdioden in oder an einem den Geberbedienknopf umgebenden, beschrifteten Feld bestehen.

5. Verfahren für die Anwendung eines Endlos-Gebers nach Anspruch 1, dadurch gekennzeichnet, daß die Anzeigen als beschriftete Flächen ausgebildet sind, die von unten wahlweise von Leuchtmitteln kenntlich gemacht werden können.

6. Verfahren für die Anwendung eines Endlos-Gebers nach Anspruch 1, dadurch gekennzeichnet, daß die Anzeigen aus Anzeigeelementen bestehen, die in Schriftform die ausgewählte Hauptfunktion kennzeichnen.

7. Verfahren für die Anwendung eines Endlos-Gebers nach Anspruch 1, dadurch gekennzeichnet, daß der mit dem Drehgeber gekoppelte Schalter bei einer erneuten Betätigung nach beendigter Dreheinstellung der Funktion die Abspeicherung der Einstellung auslöst und die Funktions-Auswahl aufhebt.

8. Verfahren für die Anwendung eines Endlos-Gebers nach Anspruch 1, dadurch gekennzeichnet, daß nach erfolgter Einstellung des Drehgebers eine erneute Betätigung des mit dem Dehgeber gekoppelten Schalters eine Abspeicherung des Einstellwertes für die angewählte Funktion und/oder die Weiterschaltung zur folgenden Funktion bewirkt.

9. Verfahren für die Anwendung eines Endlos-Gebers nach Anspruch 1, dadurch gekennzeichnet, daß die Abspeicherung eines eingestellten Wertes am Drehgeber für eine Funktion und/oder die Aufhebung oder Weiterschaltung der Funktion selbsttätig nach einer programmierten Zeit erfolgt.

10. Drehbetätigter Endlos-Geber für die Anwendung in einem Verfahren nach Anspruch 1, dadurch gekennzeichnet, daß der Geber mit mit mindestens einem Druck- und/oder Zug-Schalter an der Achse und/oder am Gehäuse ausgestattet ist, wobei die Schalterfunktion bei axialer und/oder radialer Betätigung der Drehachse und/oder des Gehäuses des Gebers betätigt wird.

## Claims

1. Method for the use of a rotary operated continuous encoder for digital pulses in a consumer electronics device, which, in operation, generates one of two pulse trains which are phase-shifted relative to each other in dependence on the direction of rotation, which trains enable the direction of rotation to be identified by means of electronic circuitry co-operating with a microcomputer, characterised in that, the rotational movement of the rotary encoder is used for selecting functions as well as for the adjustment of the function and a switch coupled to the rotary encoder assigns to the rotary encoder the functions selection, or functions adjustment, as well as receipt and/or storage processes, i.e. calls for the execution of the adjustment, by supplying switching signals in a pre-arranged sequence.

2. Method for the use of a continuous encoder according to claim 1, characterised in that, the switch coupled to the rotary encoder is constructed as a push- and/or pull actuatable switch.

3. Method for the use at a continuous encoder according to claim 1, characterised in that, for each function that has just been selected, a corresponding indication of receipt of an optical and/or acoustical kind is effected by means provided therefor.

4. Method for the use of a continuous encoder according to claim 1, characterised in that, the displays consist of light emitting diodes in or on a labelled field surrounding the operating knob for the encoder.

5. Method for the use of a continuous encoder according to claim 1, characterised in that, the displays are formed as labelled surfaces which can be selectively made visible by light means from below.

6. Method for the use of a continuous encoder according to claim 1, characterised in that, the displays consist of display elements which identify the selected main function in written form.

7. Method for the use of a continuous encoder according to claim 1, characterised in that, the switch coupled to the rotary encoder initiates the storage of the adjustment with each new actuation after rotational adjustment of the function is finished and cancels the function selection.

8. Method for the use of a continuous encoder according to claim 1, characterised in that, after the adjustment of the rotatable encoder is finished, a renewed actuation of the switch coupled to the rotary encoder causes a storage of the value of the adjustment for the selected function and/or the further switching to the following function.

9. Method for the use of a continuous encoder according to claim 1, characterised in that, the storage of an adjusted value at the rotatable encoder for a function and/or the cancellation or further switching of the function is effected automatically after a programmed time.

10. Rotary operated continuous encoder for use in a method according to claim 1, characterised in that, the encoder is equipped with at least one push and/or pull switch on the rotary shaft and/or the housing whereby the switching function is effected by axial and/or radial actuation of the rotary shaft and/or the housing of the encoder.

## Revendications

1. Procédé pour l'utilisation d'un générateur sans fin d'impulsions numériques actionné par rotation dans un appareil de l'électronique des loisirs qui produit, lorsqu'il est actionné, l'une des deux séquences d'impulsions, décalées en phase l'une par rapport à l'autre selon le sens de rotation, qui permettent de reconnaître le sens de la rotation au moyen d'organes de circuit électroniques qui coopèrent avec un micro-ordinateur, **caractérisé en ce** que le sens de rotation du générateur est utilisé aussi bien pour sélectionner la fonction que pour régler la fonction et qu'un commutateur, qui est couplé au générateur rotatif, attribue les fonctions sélection ou les fonctions réglage ainsi que les opérations de validation et/ou de mise en mémoire en donnant des signaux de commutation dans un ordre convenu au générateur rotatif, c'est-à-dire appelle la réalisation du réglage.

2. Procédé pour l'utilisation d'un générateur sans fin d'impulsions selon la revendication 1, **caractérisé en ce** que le commutateur qui est coupé au générateur rotatif est configuré comme un commutateur qui peut être actionné par pression et/ou traction.

3. Procédé pour l'utilisation d'un générateur sans fin d'impulsions selon la revendication 1, **caractérisé en ce** qu'une réponse correspondante de type visuel et/ou sonore est effectuée par l'intermédiaire de moyens prévus à cet effet pour chaque fonction qui vient d'être sélectionnée.

4. Procédé pour l'utilisation d'un générateur sans fin d'impulsions selon la revendication 1, **caractérisé en ce** que les affichages sont constitués par des diodes lumineuses dans ou sur un panneau pourvu de légendes qui entoure le bouton de manipulation du générateur.

5. Procédé pour l'utilisation d'un générateur sans fin d'impulsions selon la revendication 1, **caractérisé en ce** que les affichages sont configurés comme des surfaces pourvues de légendes qui peuvent être rendues identifiables par le bas au choix par des organes lumineux.

6. Procédé pour l'utilisation d'un générateur sans fin d'impulsions selon la revendication 1, **caractérisé en ce** que les affichages sont constitués par des éléments d'affichage qui caractérisent sous forme écrite la fonction principale sélectionnée.

7. Procédé pour l'utilisation d'un générateur sans fin d'impulsions selon la revendication 1, **caractérisé en ce** que le commutateur qui est couplé au générateur rotatif déclenche, lors d'un nouvel actionnement après achèvement du réglage par rotation de la fonction, la mise en mémoire du réglage et supprime la sélection de la fonction.

8. Procédé pour l'utilisation d'un générateur sans fin d'impulsions selon la revendication 1, **caractérisé en ce** qu'après que le réglage du générateur rotatif ait été effectué un nouvel actionnement du commutateur couplé au générateur rotatif provoque une mise en mémoire de la valeur de réglage pour la fonction sélectionnée et/ou le transfert à la fonction suivante.

9. Procédé pour l'utilisation d'un générateur sans fin d'impulsions selon la revendication 1, **caractérisé en ce** que la mise en mémoire d'une valeur réglée sur le générateur rotatif pour une fonction et/ou la suppression ou le transfert de la fonction est effectuée automatiquement après un temps programmé.

10. Générateur sans fin d'impulsions actionné par rotation pour l'utilisation dans un procédé selon la revendication 1, **caractérisé en ce** que le générateur est équipé d'au moins un commutateur à pression et/ou à tirette sur l'axe et/ou sur le bâti, le fonctionnement du commutateur étant actionné lors de l'actionnement axial et/ou radial de l'axe de rotation et/ou du bâti du générateur.
